(19) Europäisches Patentamt
European Patent Office
Office européen des brevets

(11) **EP 4 757 221 A1**

(12) **EUROPEAN PATENT APPLICATION**

(43) Date of publication:
**10.06.2026 Bulletin 2026/24**

(21) Application number: **25220391.4**

(22) Date of filing: **03.12.2025**

(51) International Patent Classification (IPC):
***H04L 1/00*** *(2006.01)*

(52) Cooperative Patent Classification (CPC):
**H04L 1/0025; H04L 1/0002; H04L 1/0009**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **03.12.2024 KR 20240177816
13.02.2025 KR 20250018898**

(71) Applicant: **Samsung Electronics Co., Ltd.
Suwon-si, Gyeonggi-do 16677 (KR)**

(72) Inventors:
• **CHOI, Soonwoo
16677 Suwon-si (KR)**
• **JEON, Eun Sung
Suwon-si 16677 (KR)**
• **BAIK, Jonghyun
16677 Suwon-si (KR)**

(74) Representative: **Marks & Clerk LLP
15 Fetter Lane
London EC4A 1BW (GB)**

(54) **DEVICE AND METHOD FOR WIRELESS COMMUNICATION INCLUDING TRANSMISSION OF INDICATION OF A SUPPORTED CODE RATE OF AN LDPC CODE**

(57) A wireless communication method by a first device, the method includes transmitting, to a second device, first capability information that identifies at least one code rate supported by a first low density parity check (LDPC) code, and receiving a signal that is encoded based on the first capability information and the first LDPC code.

FIG. 5

**Description**

FIELD

Example embodiments relate to communication, and specifically, relate to a device and a method for wireless communication.

BACKGROUND

With the advent of electronic devices such as smartphones, tablet PCs and laptops, the demand for high-speed wireless connectivity has exploded. Driven by these trends and the growing demand for high-speed wireless connectivity, in the information technology (IT) industry, the institute of electrical and electronics engineers (IEEE) 802.11 wireless communication standard is firmly established as a representative and universal high-speed wireless communication standard. Early wireless Local Area Network (LAN) technologies developed around 1997 could support transmission speeds of up to 1 to 2 Mbps. Since then, with the demand for faster wireless connections and the steady development of wireless LAN technology, new wireless LAN technologies that improve transmission speeds, such as IEEE 802.11n, 802.11ac and 802.11ax, have been steadily developed. In IEEE 802.11 ax, the maximum transmission speed reaches several Gbps.

Wireless LANs cover a variety of public places, such as offices, airports, stadiums and stations, in addition to private places like homes, and provide high-speed wireless connectivity to users everywhere in society.

SUMMARY

An aspect provides a device and a method for processing low density parity check (LDPC) codes with extended lengths in wireless communications using limited memory.

According to an aspect, a wireless communication method of a first device comprises transmitting, to a second device, first capability information that identifies at least one code rate supported by a first low density parity check (LDPC) code; and receiving a signal that is encoded based on the first capability information and the first LDPC code.

The first capability information may identify at least one code rate of the first LDPC code that the first device supports. The method may further comprise receiving, from the second device, second capability information that identifies at least one code rate of the first LDPC code that the second device supports. The received signal may have been encoded based using the first LDPC code based on the first capability information and the second capability information. The received signal may be encoded according to a code rate that is supported by both the first device and the second device (e.g., as indicated by the first capability information and the second capability information). The first capability information may indicate a code rate supported by the first device based on a size of available memory in the first device for use in decoding. Similarly, the second capability information may indicate a code rate supported by the second device based on a size of available memory in the second device for use in decoding.

According to an aspect, a wireless communication method comprises receiving, from the second device, second capability information that identifies at least one code rate that is supported by the first LDPC code of the second device; encoding a signal based on the second capability information and the first LDPC code; and transmitting, to the second device, the signal encoded based on the first capability information and the first LDPC code.

According to an aspect, a first device configured to communicate with a second device, the first device comprising: a transceiver; and a processor configured to transmit and receive signals to and from the transceiver, wherein the transceiver is configured to: transmit, to the second device, first capability information that identifies at least one code rate supported by a first LDPC code of the first device; and receive a signal that is encoded based on the first capability information and the first LDPC code.

At least some of the above and other features of the invention are set out in the claims.

BRIEF DESCRIPTION OF THE FIGURES

These and/or other aspects, features, and advantages of the invention will become apparent and more readily appreciated from the following description of example embodiments, taken in conjunction with the accompanying drawings of which:

FIG. 1 is a drawing illustrating a wireless communication system according to an example embodiment;
FIG. 2 is a block diagram illustrating a wireless communication system according to an example embodiment;
FIG. 3A and FIG. 3B are drawings illustrating a parity-check matrix and a Tanner graph according to an example embodiment;

FIG. 4A, FIG. 4B, FIG. 4C, and FIG. 4D are diagrams illustrating parity-check matrices of LDPC codes according to code rates according to an example embodiment;

FIG. 5 is a drawing illustrating a downlink transmission method according to an example embodiment;

FIG. 6 is a drawing illustrating an uplink transmission method according to an example embodiment;

FIG. 7A and 7B are flowcharts illustrating methods for transmitting and receiving capability information according to an example embodiment;

FIG. 8 is a flowchart illustrating a method for a wireless communication device to determine a code rate and transmit coded data according to an example embodiment;

FIG. 9 is a flowchart illustrating a method for a wireless communication device to determine a code rate and receive a coded signal according to an example embodiment;

FIG. 10A and FIG. 10B are drawings illustrating examples of capability information according to an example embodiment;

FIG. 11 is a drawing illustrating capability information according to an example embodiment;

FIG. 12 illustrates capability information according to an example embodiment; and

FIG. 13 is a drawing illustrating examples of devices for wireless communication according to an example embodiment.

DETAILED DESCRIPTION

Throughout the specification, when a component is described as "including" a particular element or group of elements, it is to be understood that the component is formed of only the element or the group of elements, or the element or group of elements may be combined with additional elements to form the component, unless the context clearly and/or explicitly describes the contrary.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

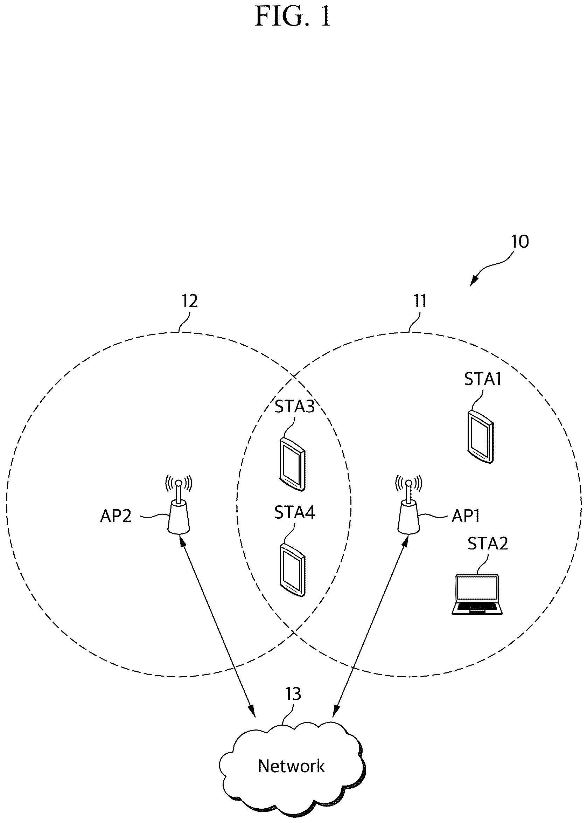

FIG. 1 is a drawing illustrating a wireless communication system according to an example embodiment. Specifically, FIG. 1 illustrates a wireless local area network (WLAN) system as an example of a wireless communication system 10.

Specific example embodiments are described with respect to a wireless communication system based on orthogonal frequency division multiplexing (OFDM) or orthogonal frequency division multiplexing access (OFDMA), especially the IEEE 802.11 standard. However, the present disclosure is applicable to other communication systems having similar technical backgrounds and channel types, for example, cellular communication systems such as long term evolution (LTE), LTE-advanced (LTE-A), new radio (NR), wireless broadband (WiBro) and global system for mobile communication (GSM), or short-range communication systems such as Bluetooth and near field communication (NFC), without departing from the scope of the present disclosure.

The various functions described below may be implemented or supported by artificial intelligence technology or one or more computer programs. Each of the programs consists of computer-readable program code and is implemented on a computer-readable medium. The terms "application" and "program" refer to one or more computer programs, software components, sets of instructions, procedures, functions, objects, classes, instances, associated data, and portions thereof suitable for implementing suitable computer-readable program code. The term "computer-readable program code" includes all types of computer code, including source code, object code and executable code. The term "computer-readable media" includes any type of media that may be accessed by a computer, such as ROM, RAM, hard disk drives, CDs, DVDs, and any other type of memory. A "non-transitory" computer-readable medium excludes wired, wireless, optical, or other communication links that transmit transitory electrical or other signals. The non-transitory computer-readable media include media on which data may be stored permanently, and media on which data may be stored and later overwritten, such as rewritable optical disks or erasable memory devices.

The various example embodiments described below illustrate hardware-based approaches. However, since the various example embodiments of the present disclosure include techniques using both hardware and software, various example embodiments of the present disclosure do not exclude software-based approaches. Further, terms referring to control information, terms referring to entries, terms referring to network entities, terms referring to messages, terms referring to device components and so on used in the following description are examples for convenience of explanation. Therefore, the present disclosure is not limited to the terms described below, and other terms having equivalent technical meaning may be used.

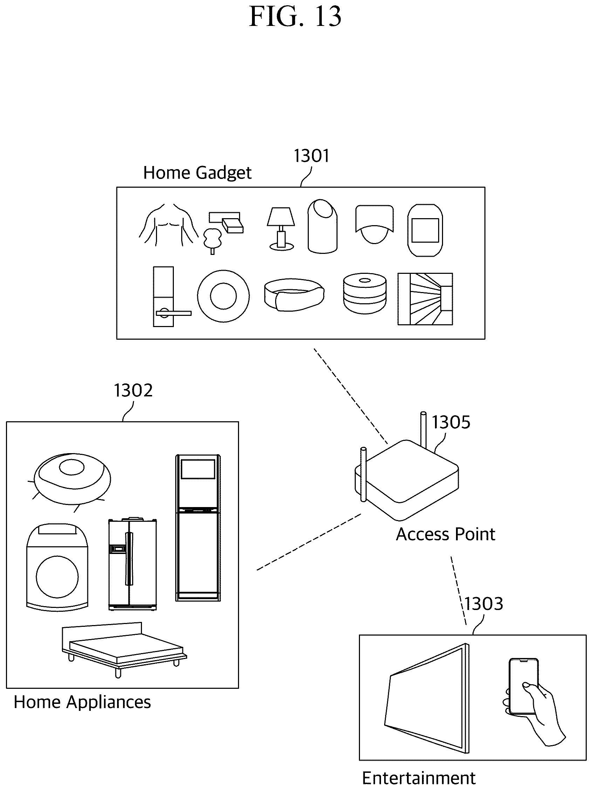

Referring to FIG. 1, the wireless communication system 10 may include a first access point AP1 and a second access point AP2, a first station STA1, a second station STA2, a third station STA3, and a fourth station STA4. The first access point AP1 and the second access point AP2 may be connected to a network 13, which may include the Internet, an internet protocol (IP) network, or any other arbitrary network. The first access point AP1 may provide access to the network 13 within a first coverage area 11 to the first station STA1, the second station STA2, the third station STA3 and the fourth station STA4, and the second access point AP2 may also provide access to the network 13 within a second coverage area 12 to the third station STA 3 and the fourth station STA 4. In some example embodiments, the first access point AP1 and the second access point AP2 may communicate with at least one of the first station STA1, the second station STA2, the third station STA3 and the fourth station STA4 based on the wireless fidelity (WiFi) or any other WLAN access technology. Example embodiments of access points and stations will be described later with reference to FIG. 13.

An access point may be referred to as a router, gateway and so on. A station may be referred to as a mobile station, a subscriber station, a terminal, a mobile terminal, a wireless terminal, user equipment, or a user. The station may be a mobile device, such as a mobile phone, a laptop computer and a wearable device, or may be a stationary device, such as a desktop computer and a smart TV. In some example embodiments, an access point (for example, the first access point AP1) and a station (for example, the first station STA1) may be collectively referred to as a communication device. A device that transmits a signal may be referred to as a transmitting device, or a transmitter, and a device that receives a signal may be referred to as a receiving device or a receiver.

The transmitter may transmit a modulated signal to a receiver. For example, the first access point AP1 may generate a signal modulated according to a predefined modulation method, and transmit the modulated signal to the first station STA1. The first station STA1 may demodulate the signal received from the first access point AP1 according to a predefined modulation method, and obtain information from the demodulated signal.

The transmitter may transmit a coded signal to the receiver. For example, the first access point AP1 may generate a signal coded according to the generator matrix of a predefined error correction code, and transmit the coded signal to the first station STA1. The first station STA1 may decode the signal received from the first access point AP1 according to the parity check matrix of the predefined error correction code, and may obtain information in which the error is corrected from the decoded signal.

In the IEEE 802.11 standard, a LDPC code is applied as error correction code, and thus a transmitter may encode data using a common LDPC code, and a receiver may decode the received signal. Here, the LDPC code may have various code rates, and depending on each code rate, a generator matrix and a parity-check matrix of the LDPC code may exist. The code rate is the ratio of the number of message or information bits (e.g., information block length) to the total number of encoded bits (e.g., codeword block length). For example, a code rate of 1/2 means that the number of message or information bits is 50% of the total number of encoded bits. With respect to the LDPC code, as the code rate decreases, or, as the length of the coded data increases compared to the data to be transmitted, error correction capability may be improved. For example, for a code rate of 1/2, 50% of the total encoded bits are message or information bits, and the remaining 50% of the total encoded bits are parity bits that are used to detect errors during transmission. Further, with respect to the LDPC code, the longer the codeword at the same code rate, the more the error correction capability may be improved. Here, a codeword may represent the length of the entire bit coded as an error correction code.

[Table 1] below shows the parameters related to the LDPC code applied in the IEEE 802.11-2020 standard.

[Table 1]

| Code rate (R) | LDPC information block length (bits) | LDPC codeword block length (bits) |
|---|---|---|
| 1/2 | 972 | 1944 |
| 1/2 | 648 | 1296 |
| 1/2 | 324 | 648 |
| 2/3 | 1296 | 1944 |
| 2/3 | 864 | 1296 |
| 2/3 | 432 | 648 |
| 3/4 | 1458 | 1944 |
| 3/4 | 972 | 1296 |
| 3/4 | 486 | 648 |
| 5/6 | 1620 | 1944 |
| 5/6 | 1080 | 1296 |
| 5/6 | 540 | 648 |

As shown in [Table 1], in the IEEE 802.11-2020 standard, 1/2, 2/3, 3/4 and 5/6 may be applied as the code rate (R) of the LDPC code, and 1944 bit may be applied as the longest codeword length. In the present disclosure, as in the IEEE 802.11-2020 standard, an LDPC code with a maximum codeword length of 1944 bits may be referred to as 1xLDPC.

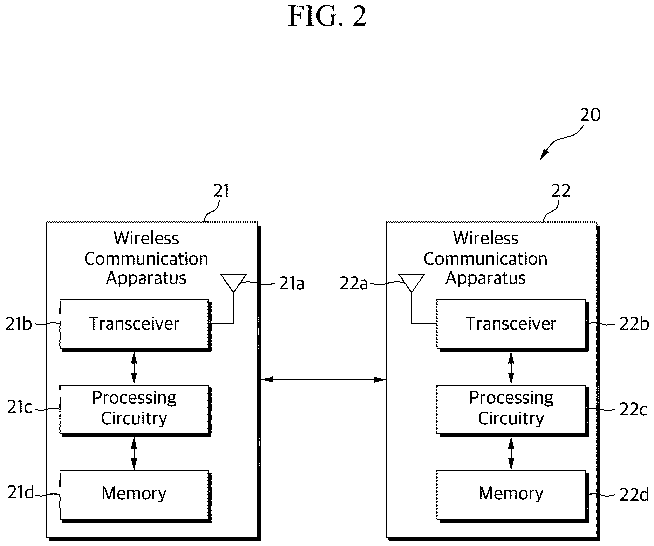

FIG. 2 is a block diagram illustrating a wireless communication system 20 according to an example embodiment. Specifically, the block diagram of FIG. 2 illustrates a first wireless communication device 21 and a second wireless communication device 22 communicating with each other in a wireless communication system 20. Each of the first wireless communication device 21 and the second wireless communication device 22 may be any device communicating in the wireless communication system 20, and may be referred to as a device for wireless communication or simply a device. In some example embodiments, each of the first wireless communication device 21 and the second wireless communication device 22 may be referred to as an access point or station of a WLAN system.

Referring to FIG. 2, the first wireless communication device 21 may include an antenna 21a, a transceiver 21b, a processing circuit 21c, and a memory 21d. In some example embodiments, the antenna 21a, the transceiver 21b, the processing circuit 21c and the memory 21d may be included in one package (e.g., as part of the first wireless communication device 21), or each may be included in different packages. The second wireless communication device 22 may also include an antenna 22a, a transceiver 22b, a processing circuit 22c, and a memory 22d. Hereinafter, repetitive descriptions regarding the first wireless communication device 21 and the second wireless communication device 22 will be omitted.

The antenna 21a may receive a signal from the second wireless communication device 22 and provide the signal to the transceiver 21b. In addition, the antenna 21a may receive a signal from the transceiver 21b and may transmit the signal to the second wireless communication device 22. In some example embodiments, the antenna 21a may include multiple antennas configured for multiple-input multiple-output (MIMO) operation. Further, in some example embodiments, the antenna 21a may include a phased array for beamforming.

The transceiver 21b may process signals received from the second wireless communication device 22 via the antenna 21a, and may provide the processed signal to the processing circuit 21c. Further, the transceiver 21b may process the signal provided from the processing circuit 21c, and output the processed signal through the antenna 21a. In some example embodiments, the transceiver 21b may include analog circuits such as low noise amplifiers, mixers, filters, power amplifiers, oscillators and so on. In some example embodiments, the transceiver 21b may process a signal received from the antenna 21a based on the control of the processing circuit 21c and/or a signal received from the processing circuit 21c.

The processing circuit 21c may extract information transmitted by the second wireless communication device 22 by processing the signal received from the transceiver 21b. For example, the processing circuit 21c may extract information by demodulating and/or decoding the signal received from the transceiver 21b. Further, the processing circuit 21c may generate a signal including information to be transmitted to the second wireless communication device 22 and provide the signal to the transceiver 21b. For example, the processing circuit 21c may provide a signal generated by encoding and/or modulating data to be transmitted to the second wireless communication device 22 to the transceiver 21b. In some example embodiments, the processing circuit 21c may include programmable components such as a central processing unit (CPU), a digital signal processor (DSP) and so on, may include reconfigurable components, such as a field programmable gate array (FPGA), and/or may include components that provide fixed functions, such as an intellectual property (IP) core. In some example embodiments, the processing circuit 21c may also include memory for storing data and/or a series of instructions, or may access external memory, such as the memory 21d.

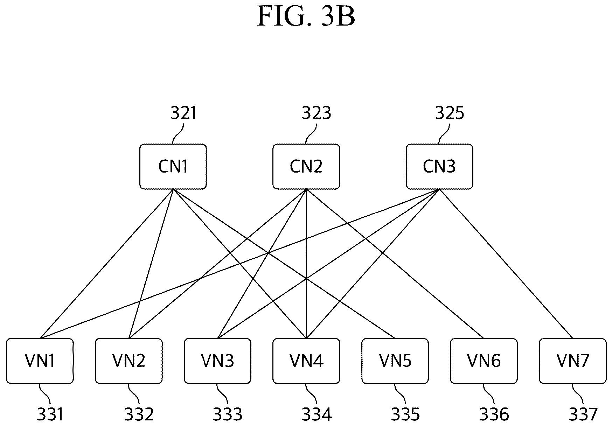

The memory 21d may be accessed by the processing circuit 21c of the first wireless communication device 21, and may store various data. The data may include input data or output data for software (for example, a program) and instructions associated therewith. For example, the memory 21d may store data related to the generator matrix of error correction code for encoding data, and may store data related to the parity-check matrix of the error correction code for decoding data received from the transceiver 21b. For example, the memory 21d may store data to be used for operation in the check node of the parity-check matrix described later in FIG. 3B. Further, the memory 21d may include volatile memory (for example, DRAM) and/or non-volatile memory (for example, flash memory) for storing data.

In the present disclosure, with regard to the transceiver 21b and/or the processing circuit 21c performing operations, the operations may be described as being simply performed by the first wireless communication device 21. Accordingly, operations performed by an access point may be performed by a transceiver and/or processing circuit included in the access point. Operations performed by a station may be performed by a transceiver and/or processing circuit included in the station.

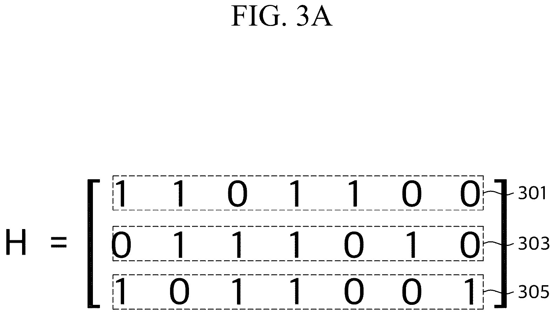

FIG. 3A and FIG. 3B are drawings illustrating a parity-check matrix and a Tanner graph according to an example embodiment of the present disclosure. The parity-check matrix of FIG. 3A defines the constraints of the LDPC code and describes the relationships between check nodes and variable nodes. The Tanner graph of FIG. 3B is a bipartite graph that expresses constraints that specify an error correcting code.

When the number of information bits before encoding is K and the length of the entire codeword is N, the parity-check matrix of an error correction code may have the size of $(N-K) \times N$, where K and N are integers greater than 0. Further, the code rate of error correction code may be expressed as K/N. For example, in the case of the 1xLDPC code of which code rate is 3/4 and the entire codeword length is 1944 bits, the parity-check matrix has a size of bits of 486 x 1944.

Referring to FIG. 3A and FIG. 3B, in an example embodiment, the parity-check matrix H of the error correction code may be expressed as a 3x7 matrix. A row of the parity-check matrix H may be represented as a check node in the Tanner graph, and a column of the parity-check matrix H may be represented as a variable node in the Tanner graph. In this case, the number of rows in the parity-check matrix H may be expressed as the number of check nodes in the Tanner graph, and the number of columns may be expressed as the number of variable nodes in the Tanner graph. Further, when a check node and a variable node are connected to each other in a Tanner graph, the element of the parity-check matrix H is 1, and when the check node and variable node are not connected to each other, the element of the parity-check matrix H may be represented as 0. In the present example, since the number of rows in the parity-check matrix H is 3, the corresponding Tanner graph may include three check nodes (a first check node 321, a second check node 323 and a third check node 325), and since the number of columns in the parity-check matrix H is 7, the corresponding Tanner graph may include seven variable nodes (a first variable node 331, a second variable node 332, a third variable node 333, a fourth variable node 334, a fifth variable node 335, a sixth variable node 336 and a seventh variable node 337).

In a first row 301 of parity-check matrix H, a first column, a second column, a fourth column and a fifth column have a 1, while a third column, a sixth column, and a seventh column have a zero. Thus, in the Tanner graph, the first check node 321 may be connected to the first variable node 331, the second variable node 332, the fourth variable node 334, and the fifth variable node 335, and the first check node 321 may not be connected to the third variable node 333, the sixth variable node 336, or the seventh variable node 337. In a second row 303 of parity-check matrix H, a second column, a third column, a fourth column and a sixth column have a 1, while the first column, the fifth column, and the seventh column have a zero. Thus, in the Tanner graph, the second check node 323 may be connected to the second variable node 332, the third variable node 333, the fourth variable node 334 and the sixth variable node 336, and the second check node 323 may not be connected to the first variable node 331, the fifth variable node 335, or the seventh variable node 337. Similarly, in a third row 305 of parity-check matrix H, a first column, a third column, a fourth column and a seventh column have a 1, while the second column, the fifth column, and the sixth column have a zero. Thus, in the Tanner graph, the third check node 325 may be connected to the first variable node 331, the third variable node 333, the fourth variable node 334, and the seventh variable node 337, and the third check node 325 may not be connected to the second variable node 332, the fifth variable node 335, or the sixth variable node 336.

As illustrated in the Tanner graph of FIG. 3B, the connection between the three check nodes (the first check node 321, the second check node 323 and the third check node 325) and the seven variable nodes (the first variable node 331, the second variable node 332, the third variable node 333, the fourth variable node 334, the fifth variable node 335, the sixth variable node 336 and the seventh variable node 337) is determined from the parity-check matrix H. After these connections are determined, each of the seven variable nodes (the first variable node 331, the second variable node 332, the third variable node 333, the fourth variable node 334, the fifth variable node 335, the sixth variable node 336 and the seventh variable node 337) may be given or inputted a log-likelihood ratio (LLR) value (e.g., wherein the value is a real number between 0 and 1, inclusive) that is calculated from the signal received by the receiver. When the LLR values are entered into each of the seven variable nodes (the first variable node 331, the second variable node 332, the third variable node 333, the fourth variable node 334, the fifth variable node 335, the sixth variable node 336 and the seventh variable node 337), a check-sum operation may be performed on each of the three check nodes (the first check node 321, the second check node 323 and the third check node 325) connected to the seven variable nodes (the first variable node 331, the second variable node 332, the third variable node 333, the fourth variable node 334, the fifth variable node 335, the sixth variable node 336 and the seventh variable node 337).

The check-sum operation may comprise various operation methods depending on the required performance. For example, the check-sum operation may be one of the Tanh-Sum operation, the min-sum operation, the normalized min-sum operation, the offset min-sum operation, the sum-product operation, and an operation based on the lookup table (LUT). The check-sum operation is a rule, or parity-check equation, that looks at certain variable nodes and determines if the value of those variable nodes is likely to be correct and error-free.

When the check-sum operation is completed at three check nodes (the first check node 321, the second check node 323 and the third check node 325) on the Tanner graph, the seven variable nodes (the first variable node 331, the second variable node 332, the third variable node 333, the fourth variable node 334, the fifth variable node 335, the sixth variable node 336 and the seventh variable node 337) may update the variable values of the variable nodes using values from the connected check nodes whose operations have ended. By repeating this process, the LLR values of the seven variable nodes (the first variable node 331, the second variable node 332, the third variable node 333, the fourth variable node 334, the fifth variable node 335, the sixth variable node 336 and the seventh variable node 337) may be updated, and once the iteration is complete, the final bit value may be determined from each LLR value. A decoding algorithm like this is called the Belief Propagation algorithm of LDPC code.

Since the check-sum operation may be complex and difficult, in the decoding process of an LDPC code, a memory of sufficient size may be used in the check-sum operation. For example, as the number of check nodes increases, the memory size required for decoding may increase.

In the IEEE 802.11-2020 standard, the parity-check matrix may be partitioned into sub-matrices of size Z x Z , where Z is an integer greater than 0. Here, each sub-matrix may be an identity matrix of size Z x Z, a matrix for which an identity matrix with size Z x Z is cyclic shifted, or 0 matrix (e.g., a zero matrix).

The cyclic shift may refer to the periodic shifting of column elements of a sub-matrix of an identity matrix. For example, if the identity matrix $P_0$ in which Z = 8 is cyclically shifted by 1 and it is called $P_1$ , each of the identity matrix $P_0$ and cyclic shift matrix $P_1$ may be represented as below [Equation 1] and [Equation 2].

【Equation 1】

$$P_0 = \begin{bmatrix} 1\,0\,0\,0\,0\,0\,0\,0 \\ 0\,1\,0\,0\,0\,0\,0\,0 \\ 0\,0\,1\,0\,0\,0\,0\,0 \\ 0\,0\,0\,1\,0\,0\,0\,0 \\ 0\,0\,0\,0\,1\,0\,0\,0 \\ 0\,0\,0\,0\,0\,1\,0\,0 \\ 0\,0\,0\,0\,0\,0\,1\,0 \\ 0\,0\,0\,0\,0\,0\,0\,1 \end{bmatrix}$$

【Equation 2】

$$P_1 = \begin{bmatrix} 0\,1\,0\,0\,0\,0\,0\,0 \\ 0\,0\,1\,0\,0\,0\,0\,0 \\ 0\,0\,0\,1\,0\,0\,0\,0 \\ 0\,0\,0\,0\,1\,0\,0\,0 \\ 0\,0\,0\,0\,0\,1\,0\,0 \\ 0\,0\,0\,0\,0\,0\,1\,0 \\ 0\,0\,0\,0\,0\,0\,0\,1 \\ 1\,0\,0\,0\,0\,0\,0\,0 \end{bmatrix}$$

Hereinafter, when Z x Z sub-matrix of the parity-check matrix is an identity matrix, "0" is presented, when Z x Z sub-matrix is 0 matrix, "-1" is presented, and when Z x Z sub-matrix is cyclic shifted as much as a, "a" is presented.

As described above in [Table 1], in the IEEE 802.11-2020 standard, 1/2, 2/3, 3/4 and 5/6 may be applied as code rates (R) of an 1xLDPC code, and 1944 bit may be applied as the maximum codeword length. Further, when the maximum codeword length of an 1xLDPC code is 1944 bit, a Z value may be 81, and when one sub-matrix is replaced with a number such as "0," "-1" and "a," the parity-check matrix may be expressed in a form that is 1/81 the size of the original matrix. The matrix that represents the parity-check matrix of the 1xLDPC code in a reduced form has the size of 12 x 24 when the code rate is 1/2. A value associated with the complexity of the check-sum operation of a matrix expressed in reduced form is 12, which is the number of rows in the matrix, and in the present disclosure, the number of rows in a matrix expressed in a reduced form of a parity-check matrix may be equivalent to the number of layers. When decoding data received by the receiver, the number of layers may be a factor in determining memory size.

In order to improve the error correction, the length of a codeword of an LDPC code may be increased. In the present disclosure, an LDPC code with a maximum codeword length greater than that of a 1xLDPC code may be represented as a 2xLDPC code. For example, when the maximum codeword length of the 1xLDPC code is 1944 bits, the maximum codeword length of the 2xLDPC code may be 3888 bits (e.g., twice the maximum codeword length of the 1xLDPC code).

[Table 2] below shows the number of layers according to the code rate of the 1xLDPC code and the 2xLDPC code with the maximum codeword length of 3888.

[Table 2]

| Code rate (R) | Number of Layers | |
|---|---|---|
| | 1xLDPC | 2xLDPC |
| 1/2 | 12 | 24 |
| 2/3 | 8 | 16 |
| 3/4 | 6 | 12 |
| 5/6 | 4 | 8 |

In [Table 2], for the 1xLDPC code, the maximum number of layers is 12 with the code rate of 1/2, and for the 2xLDPC code, the maximum number of layers is 24 with the code rate of 1/2. Therefore, when the transmitter transmits a signal using the 2xLDPC code with the code rate of 1/2, the receiver may need at least twice the memory size for the check node in the 1xLDPC code. However, when the transmitter transmits a signal using the 2xLDPC code with the code rate of 1/2, the receiver may correct errors in the received data only if the receiver supports the 2xLDPC code.

When the transmitter transmits a signal using the 2xLDPC code with code rate of 3/4 or 5/6, since the maximum number of layers is 12, the receiver supporting the 1xLDPC code may decode data that is encoded with the 2xLDPC code with the code rate of 3/4 or 5/6 without increasing the memory size. For example, with the code rate (e.g., of 3/4 or 5/6) of the 2xLDPC code having a number of layers (e.g., 12 layers or 8 layers, respectively) that is less than or equal to the maximum number of layers of the 1xLDPC code (e.g., a maximum of 12 layers for the 1/2 code rate), the receiver is able to decode the 2xLDPC code with the memory size of the 1xLDPC code.

Various example embodiments of the present disclosure may disclose a method or a wireless communication device for transmitting or receiving information on a code rate of the 2xLDPC code that is supported among wireless communication devices. For example, the wireless communication device may be an access point or a station, and code rate information may be transmitted or received as part of capability information. Here, the capability information is information that indicates the capabilities of a wireless communication device. The capability information is not limited to being referred to as 'capability information', and, instead, may be referred to by other terms (e.g., identifying information, capability details, etc.) that perform the corresponding function. The capability information may comprise, for example, the code rate that is supported by the LDPC code (e.g., 3/4 code rate for 2xLDPC, etc.), information (e.g., in the form of one or more bits) indicating whether transmission by a first wireless communication device based on the 2xLDPC code is supported, information (e.g., in the form of one or more bits) indicating whether reception by the first wireless communication device based on the 2xLDPC code is supported, etc.

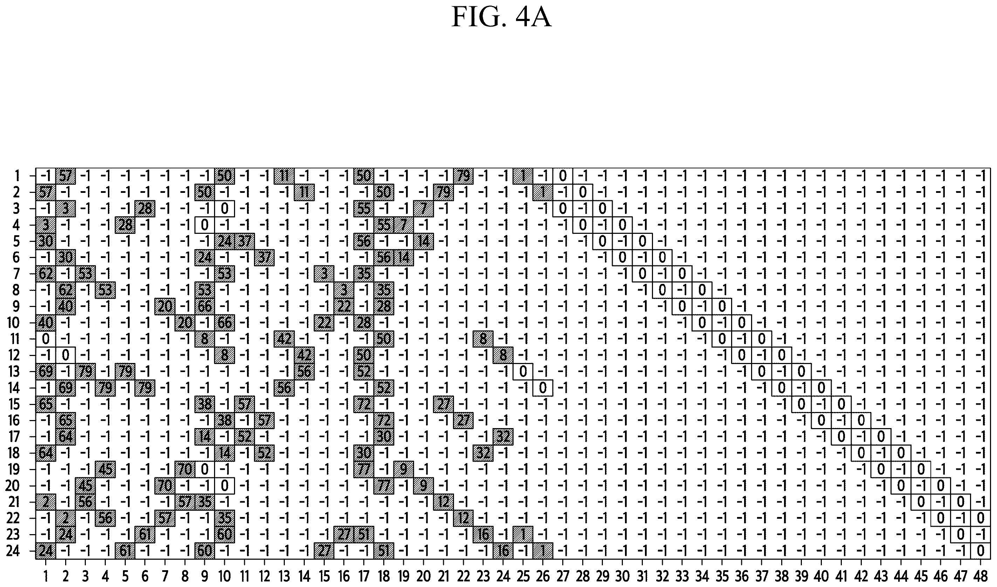

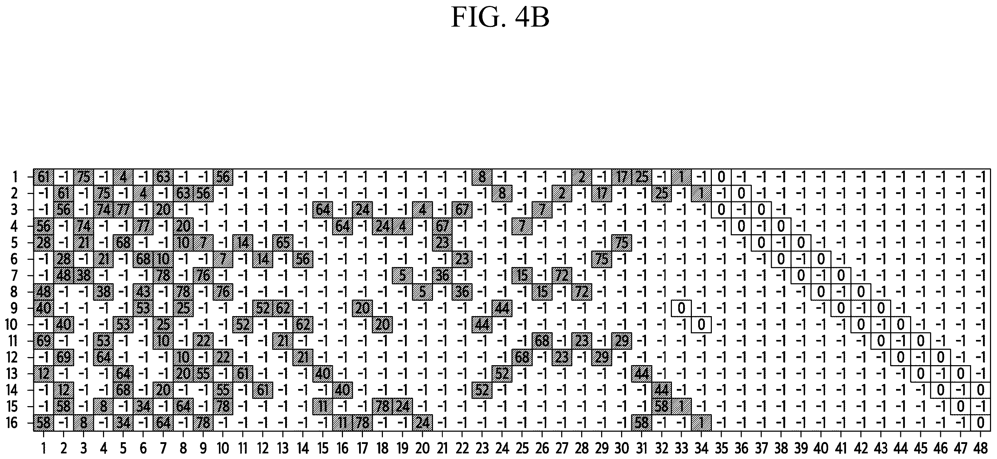

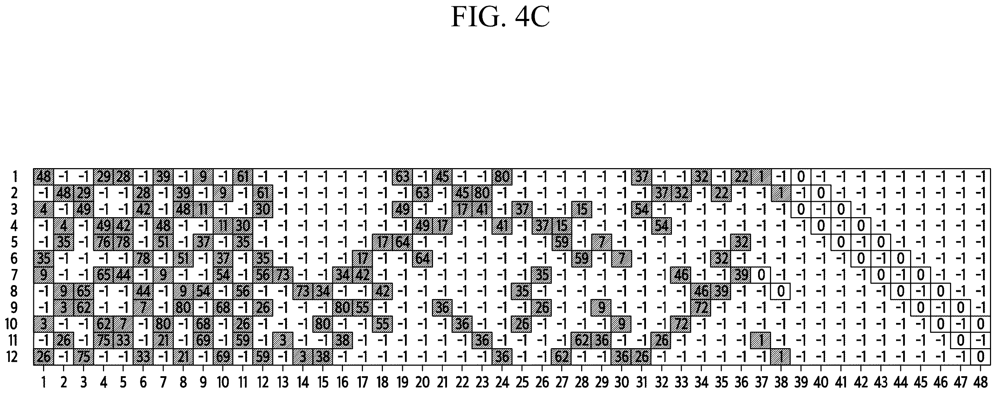

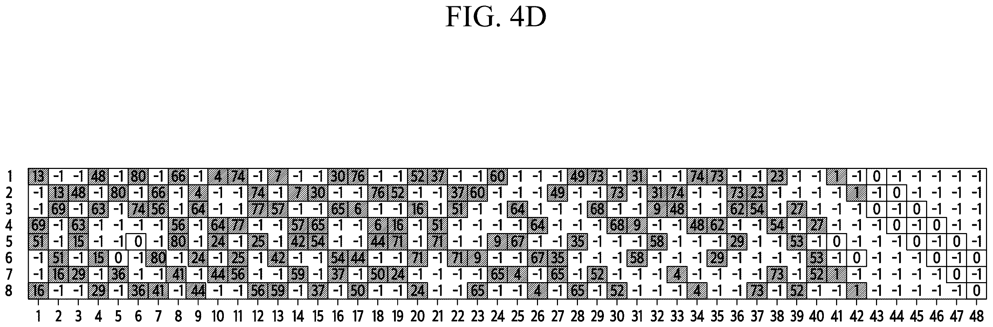

FIG. 4A, FIG. 4B, FIG. 4C, and FIG. 4D are diagrams illustrating parity-check matrices of LDPC codes according to code rates, according to an example embodiment.

FIG. 4A illustrates the reduced parity-check matrix of a 2xLDPC code with the code rate of 1/2. Specifically, the size of the reduced parity-check matrix is 24 x 48, where the codeword length is 3888 bits and Z is 81. Therefore, as shown in [Table 2], since the number of layers in 2xLDPC code is 24, the receiver may not decode the 2xLDPC code with the memory size of the 1xLDPC code due to the number of layers (e.g., 24 layers) of the 2xLDPC code in FIG. 4A being larger than the maximum number of layers (e.g., maximum of 12 layers) of the 1xLDPC code.

FIG. 4B illustrates the reduced parity-check matrix of the 2xLDPC code with the code rate of 2/3. Specifically, the size of the reduced parity-check matrix is 16 x 48, where the codeword length is 3888 bits and Z is 81. Therefore, as shown in [Table 2], since the number of layers in 2xLDPC code is 16, the receiver may not decode the 2xLDPC code with the memory size of the 1xLDPC code due to the number of layers (e.g., 16 layers) of the 2xLDPC code in FIG. 4B being larger than the maximum number of layers (e.g., maximum of 12 layers) of the 1xLDPC code.

FIG. 4C illustrates the reduced parity-check matrix of the 2xLDPC code with the code rate of 3/4. Specifically, the size of the reduced parity-check matrix is 12 x 48, where the codeword length is 3888 bits and Z is 81. Therefore, as shown in [Table 2], since the number of layers in 2xLDPC code is 12, the receiver may decode the 2xLDPC code with the memory size of the 1xLDPC code due to the number of layers (e.g., 12 layers) of the 2xLDPC code in FIG. 4C being equal to the maximum number of layers (e.g., maximum of 12 layers) of the 1xLDPC code.

FIG. 4D illustrates the reduced parity-check matrix of the 2xLDPC code with the code rate of 5/6. Specifically, the size of the reduced parity-check matrix is 8 x 48, where the codeword length is 3888 bits and Z is 81. Therefore, as shown in [Table 2], since the number of layers of the 2xLDPC code is 8, the receiver may decode the 2xLDPC code with the memory size of the 1xLDPC code due to the number of layers (e.g., 8 layers) of the 2xLDPC code in FIG. 4D being less than the maximum number of layers (e.g., maximum of 12 layers) of the 1xLDPC code.

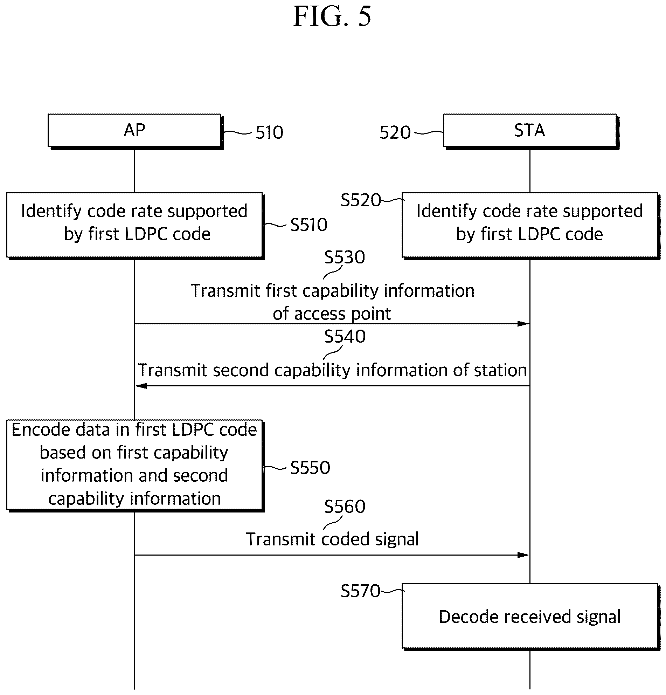

FIG. 5 is a drawing illustrating a downlink transmission method according to an example embodiment of the present disclosure.

Referring to FIG. 5, in operation S510, an access point 510 may identify the code rate supported by the first LDPC code. Specifically, the access point 510 may identify at least one code rate supported by the 2xLDPC code. For example, the access point 510 may identify the code rate that the access point 510 is configured to support as 3/4 and 5/6. In the present disclosure, the first LDPC code may indicate a 2xLDPC code, and the code rate supported by the first LDPC code is the code rate that has a number of layers that is less than, or equal to, a maximum number of layers in the 1xLDPC code. In embodiments, with the maximum number of layers in the 1xLDPC code being 12 layers, the code rate supported by the first LDPC code is 3/4 (e.g., having 12 layers) and 5/6 (e.g., having 8 layers).

In an example embodiment, the access point 510 may separately identify at least one code rate depending on whether transmission based on a 2xLDPC code is supported and depending on whether reception based on the 2xLDPC code is supported. For example, the access point 510 may be a receiver for receiving a coded signal using the 2xLDPC code, and/or may be a transmitter for encoding data and transmitting the coded data using the 2xLDPC code, and thus the access point 510 may identify at least one code rate depending on whether transmission is supported and at least one code rate depending on whether reception is supported.

In operation S520, a station 520 may identify the code rate supported by the first LDPC code. Specifically, the station 520 may identify at least one code rate that the station 520 is configured to support in a 2xLDPC code. For example, the station 520 may identify the code rates of 3/4 and 5/6 that the station 520 is configured to support due to these code rates having a number of layers that is less than, or equal to, a maximum number of layers in the 1xLDPC code. In the present disclosure, the operation S520 is described as being performed after operation S510, but in other embodiments, the order may be reversed. For example, operation S520 may be performed first, and then operation S510 may be performed. Alternatively, operations S510 and S520 may be performed in parallel (e.g., simultaneously).

In an example embodiment, the station 520 may separately identify at least one code rate depending on whether transmission based on a first LDPC code is supported and at least one code rate depending on whether reception based on the first LDPC code is supported. For example, the station 520 may be a receiver for receiving a coded signal using the 2xLDPC code, and may be a transmitter for encoding data using the 2xLDPC code and transmitting coded data. Thus, the station 520 may separately identify at least one code rate depending on whether transmission is supported and at least one code rate depending whether reception is supported.

In operation S530, the access point 510 may transmit first capability information of the access point 510 to the station 520, wherein the first capability information may be determined, at least in part, from the operation S510, in which the code rate is identified. For example, the access point 510 may transmit the first capability information including information on at least one code rate supported by the first LDPC code identified in operation S510.

In an example embodiment, the first capability information may include whether transmission based on the first LDPC code is supported (e.g., by the access point 510) and whether reception based on the first LDPC code is supported (e.g., by the access point 510). For example, the first capability information may include at least one bit indicating whether transmission based on the first LDPC code is supported and at least one bit indicating whether reception based on the first LDPC code is supported.

In an example embodiment, the first capability information may include a first bit indicating whether at least one first code rate of the first LDPC code is supported and a second bit indicating whether at least one second code rate of the first LDPC code is supported. For example, to identify whether decoding with the memory size of the 1xLDPC code is possible, at least one first code rate (e.g., as reflected by the first bit) may include 1/2 and 2/3, and at least one second code rate (e.g., as reflected by the second bit) may include 3/4 and 5/6. For instance, a first level (e.g., 1) of the first bit may indicate the at least one first code rates (e.g., 1/2 and 2/3) is supported and a second level (e.g., 0) of the first bit may indicate that the at least one first code rate (e.g., 1/2 and 2/3) is not supported. Similarly, a first level (e.g., 1) of the second bit may indicate the at least one second code rate (e.g., 3/4 and 5/6) is supported and a second level (e.g., 0) of the second bit may indicate that the at least one second code rate (e.g., 3/4 and 5/6) is not supported. Accordingly, if the first bit is 1 and the second bit is zero, then the first capability information may include the at least one first code rate, which in this case is 1/2 and 2/3. However, if the first bit is zero and the second bit is 1, then the first capability information may include the at least one second code rate, which in this case is 3/4 and 5/6.

The access point 510 may transmit the first capability information in various ways to the station 520. In an example embodiment, the access point 510 may transmit a beacon frame or a probe response frame including the first capability information to the station 520. The beacon frame and the probe response frame may be used as management frames to support the communication between the access point 510 and the station 520 in the IEEE 802.11 wireless communication standard. The beacon frame may be transmitted periodically by the access point 510 to announce the existence of a network. The beacon frame may serve to provide the station 520 with information about a network identifier (a specific service set identifier (SSID)), supported data speed, channel information, and various features and settings of the network. The beacon frame may be transmitted in broadcast form so that all stations in the network may receive it.

When the station 520 transmits a probe request frame to search for a specific network, the probe response frame may represent a management frame transmitted by the access point 510 in response to the request. The probe response frame may include similar information to the beacon frame, and is set up to allow a station attempting to join a network to check the network settings and supported functions. The probe response frame is transmitted in response to a request from a specific station, and thus the probe response frame may be transmitted directly to a single station.

In operation S540, the station 520 may transmit second capability information of the station 520 to the access point 510, wherein the second capability information may be determined, at least in part, from the operation S520, in which the code rate is identified. For example, the station 520 may transmit to the access point 510 the second capability information including at least one code rate information supported by the first LDPC code identified in operation S520. Here, the second capability information described above may be identical to or similar to the first capability information. For the convenience of explanation, it is described that operation S540 is performed after operation S530, but in other embodiments, operation S540 may be performed first, and operation S530 may be performed next. Alternatively, operations S530 and S540 may be performed in parallel (e.g., simultaneously).

The station 520 may transmit the second capability information in various ways to the access point 510. In an example embodiment, the second capability information may be transmitted by being included in a probe request frame. The probe request frame may indicate a management frame transmitted by the station 520 to search for surrounding networks or request information about a specific network in the IEEE 802.11 wireless communication standard. The probe request frame may be used to search for networks that the station 520 may connect to, or to identify the presence of a network with a specific SSID. The probe request frame may include information about the network settings and capabilities supported by the station (for example, data rates, security protocols and so on), specify a specific SSID and transmit a broadcast request to discover all networks. The access point 510, which receives a probe request frame, may transmit a probe response frame including network information (SSID, supported functions and so on) managed by the access point 510 to the corresponding station in response to the request.

In operation S550, the access point 510 may encode data in a first LDPC code based on the first capability information and the second capability information. For example, the access point 510 may analyze (e.g., compare, inspect, etc.) the first capability information and the second capability information when determining a code rate for the encoded data. For example, the access point 510 may identify a code rate that both the access point 510 and the station 520 are configured to support among the code rates that the access point 510 and the station 520 are configured to support in the first LDPC code based on the first capability information and the second capability information, and may encode data to be transmitted using the first LDPC code with the corresponding code rate. In some embodiments, the access point 510 may compare the one or more code rates indicated by the first capability information to the one or more code rates indicated by the second capability information, and the access point 510 may identify a common or shared code rate between the access point 510 and the station 520 that both the access point 510 and the station 520 support. For example, when the first capability information includes an indication that the access point 510 is configured to support code rates of 3/4 and 5/6 for the 2xLDPC code and the second capability information includes an indication that the station 520 is configured to support code rates of 3/4 and 5/6 for the 2xLDPC code, the access point 510 may encode data to be transmitted with the 2xLDPC code with 3/4 code rate or the 5/6 code rate.

In operation S560, the access point 510 may transmit the coded signal to the station 520, and in operation S570, the station 520 may decode the received signal. For example, the station 520 may receive the coded signal, and may obtain data by decoding the received signal, according to the code rate that is coded with the 2xLDPC. For example, if the access point 510 encodes the data to be transmitted with 2xLDPC code with 3/4 code rate, since the number of layers at the code rate of the 2xLDPC for encoding data is equal to the maximum number of layers of the 1xLDPC code, the station 520 may decode a signal coded at 3/4 code rate of the 2xLDPC code using memory of the capacity for the check-sum of the 1xLDPC code.

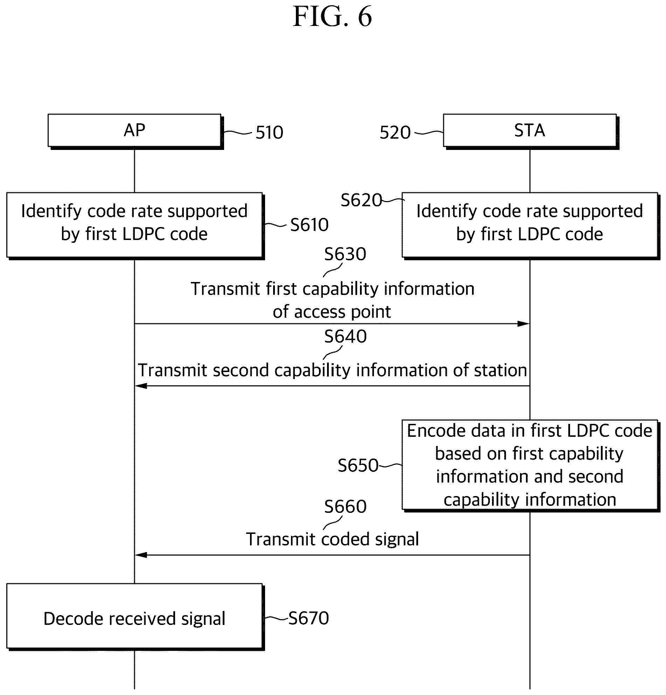

FIG. 6 is a drawing illustrating an uplink transmission method according to an example embodiment. Hereinafter, any description that overlaps with the downlink transmission method of FIG. 5 will be omitted.

Referring to FIG. 6, each of the access point 510 and the station 520 in operation S610 and operation S620 may identify at least one code rate supported by the first LDPC code (e.g., supported by the access point 510 and the station 520), and the access point 510 and the station 520 may share first capability information and second capability information including at least one code rate identified in operation S630 and operation S640 by transmitting the first capability information of the access point 510 from the access point 510 to the station 520, and by transmitting the second capability information of the station 520 from the station 520 to the access point 510. The code rates may be identified in S610 and S620 in an identical manner as the code rate identification described above in S510 and S520 of FIG. 5.

In operation S650, the station 520 may encode data in the first LDPC code based on the first capability information and the second capability information. Specifically, data to be transmitted by the station 520 may be coded using the first LDPC code with the code rate determined by the access point 510. For example, from the first capability information transmitted from the access point 510 to the station 520, the station 520 may identify that the access point 510 is configured to support the code rates of 3/4 and 5/6 with respect to the 2xLDPC code. If the second capability information indicating that the code rates of 3/4 and 5/6 are supported with respect to the 2xLDPC code is transmitted from the station 520 to the access point 510, the station 520 may encode the data to be transmitted with 2xLDPC code with 3/4 code rate or the 5/6 code rate.

In operation S660, the station 520 may transmit the coded signal to the access point 510. Specifically, in operation S660, the data-coded signal from the station 520 may be transmitted to the access point 510 through the channel.

In operation S670, the access point 510 may decode the received signal. Specifically, the access point 510 may decode the signal that contains errors as the signal passes through the channel based on the code rate and the 2xLDPC code that the station 520 encoded, and may obtain data. For example, when the station 520 encodes the data to be transmitted with 2xLDPC code with 3/4 code rate, since the number of layers at the code rate of the 2xLDPC for coding data is equal to the maximum number of layers of the 1xLDPC code, the access point 510 may decode the signal coded with 3/4 code rate of the 2xLDPC code using memory of the capacity for check-sum of the 1xLDPC code.

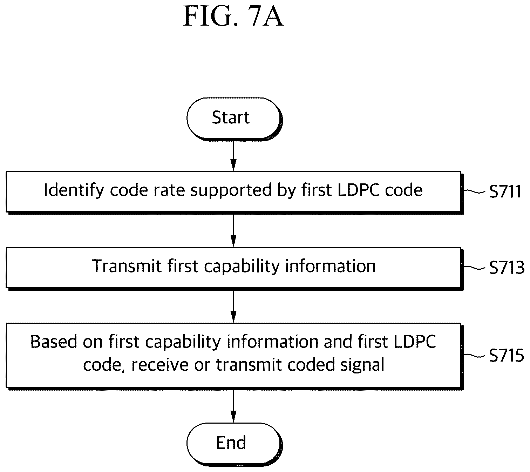

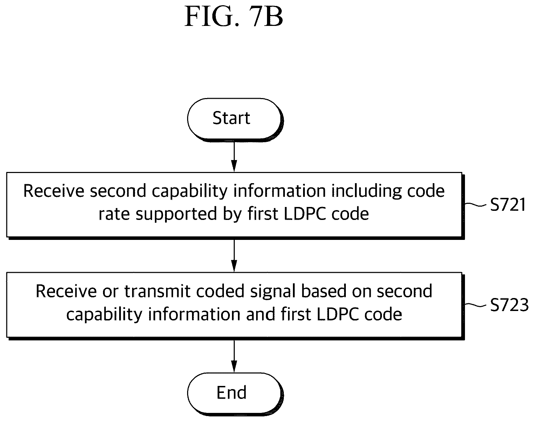

FIG. 7A and FIG. 7B are flow diagrams illustrating methods for transmitting and receiving capability information according to an example embodiment. In an example embodiment, each of the methods of FIG. 7A and FIG. 7B may be performed by either the access point 510 or the station 520 of FIGS. 5 or 6, and below, FIG. 7A and FIG. 7B will be described with reference to FIG. 5.

Referring to FIG. 7A, in operation S711, a wireless communication device according to an example embodiment may identify a code rate supported by a first LDPC code. The wireless communication device may identify a code rate of a first LDPC code supported by the wireless communication device. Specifically, the wireless communication device may identify at least one code rate that the wireless communication device is configured to support in a 2xLDPC code. Here, the wireless communication device may be the access point 510 or the station 520.

In operation S713, the wireless communication device may transmit first capability information to another wireless communication device. Specifically, the wireless communication device may transmit the first capability information including at least one identified code rate to another wireless communication device. In embodiments, the first capability information may be transmitted from the access point 510 to the station 520, or the first capability information may be transmitted from the station 520 to the access point 510.

In operation S715, the wireless communication device may receive or transmit a coded signal based on the first capability information and a first LDPC code. Specifically, the wireless communication device may select one code rate from at least one identified code rate, and transmit the data-encoded signal using the 2xLDPC code at the corresponding code rate. Alternatively, the wireless communication device may receive the data-coded signal by using the 2xLDPC code of one of the identified code rates.

Referring to FIG. 7B, in operation S721, the wireless communication device may receive second capability information including the code rate supported by the first LDPC code. Specifically, the wireless communication device may receive the second capability information including at least one code rate that another wireless communication device is configured to support. Here, the wireless communication device may be the access point 510 or the station 520.

In operation S723, the wireless communication device may receive or transmit the coded signal based on the second capability information and the first LDPC code. Specifically, the wireless communication device may transmit a signal in which data is encoded using a 2xLDPC code of at least one of the identified code rates. Alternatively, the wireless communication device may receive a signal in which data is encoded by using a 2xLDPC code of at least one code rate among the identified code rates.

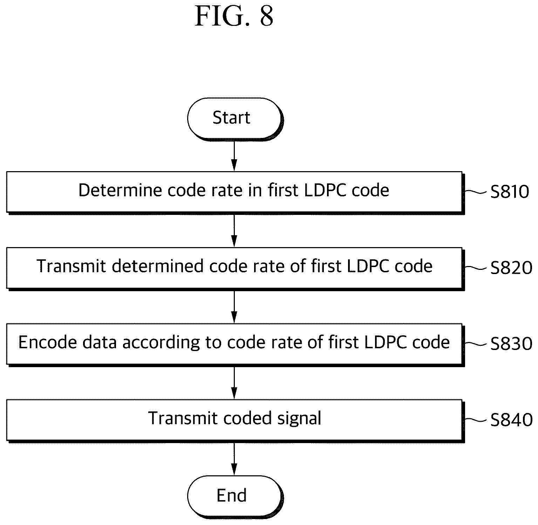

FIG. 8 is a flowchart illustrating a method of a wireless communication device determining a code rate and transmitting coded data according to an example embodiment. In an example embodiment, the method of FIG. 8 may be performed by the access point 510 or the station 520 of FIGS. 5 or 6. In the following description, the method of FIG. 8 is performed by the access point 510 of FIG. 5.

Referring to FIG. 8, in operation S810, the access point 510 may determine the code rate in the first LDPC code. For example, the access point 510 may determine a third code rate of the 2xLDPC code to be used for encoding or decoding, based on the first capability information that includes at least one code rate that the access point 510 is configured to support in the 2xLDPC code, and the second capability information that includes at least one code rate that the station 520 is configured to support in 2xLDPC code. Here, the third code rate may be a code rate commonly supported by the access point 510 and the station 520. For example, if both the access point 510 and the station 520 support a 3/4 code rate, then the third code rate may be the 3/4 code rate.

In operation S820, the access point 510 may transmit the determined code rate of the first LDPC code. For example, the access point 510 may transmit third code rate information of the 2xLDPC code determined by the access point 510 to the station 520. Accordingly, the access point 510 and the station 520 may share whether to transmit and receive coded or decoded signals with a specific code rate of the 2xLDPC code.

In operation S830, the access point 510 may encode data according to the determined code rate of the first LDPC code. Specifically, the access point 510 may encode data using a generator matrix corresponding to the determined third code rate of the 2xLDPC code.

In operation S840, the access point 510 may transmit a coded signal to the station 520, wherein the coded signal comprises the encoded data according to the third code rate of the 2xLDPC code. Specifically, the access point 510 may transmit the coded signal to the station 520 according to the IEEE 802.11 standard.

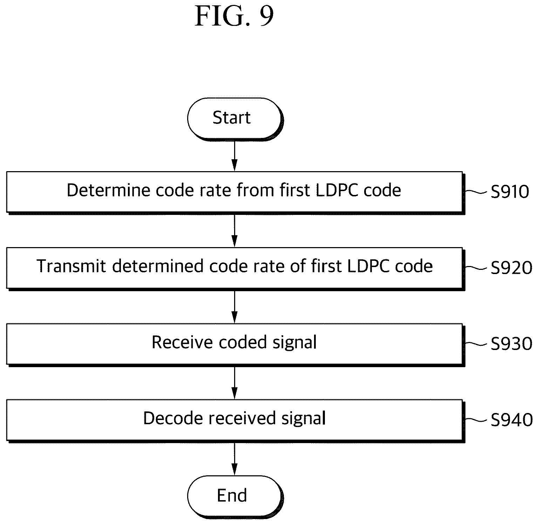

FIG. 9 is a flow chart illustrating a method of a wireless communication device determining a code rate and receiving a coded signal according to an example embodiment. In an example embodiment, the method of FIG. 9 may be performed by the access point 510 or the station 520 of FIGS. 5 or 6. In the following description, the method of FIG. 9 is performed by the access point 510 of FIG. 5. Further, description that overlaps with the method of transmitting the coded signal of FIG. 8 will be omitted.

Referring to FIG. 9, in operation S910, the access point 510 may determine the code rate to use for transmitting and receiving signals with the station 520 from the first LDPC code. In operation S920, the access point 510 may transmit the determined code rate of the first LDPC code to the station 520. In operation S930, the access point 510 may receive a coded signal from the station 520, wherein the signal is coded according to the determined code rate of the first LDPC code. For example, the access point 510 may receive coded signals from the station 520 via uplink transmissions according to the shared third code rate of the 2xLDPC code.

In operation S940, the access point 510 may decode the received signal. For example, the access point 510 may decode the received signal through the above-described decoding method using the parity-check matrix and the Tanner graph corresponding to the determined third code rate of the 2xLDPC code, and the access point 510 may obtain the data in which the error is corrected. For example, when the determined third code rate of the 2xLDPC code is 3/4, the access point 510 may decode the received signal using the memory size of the 1xLDPC code.

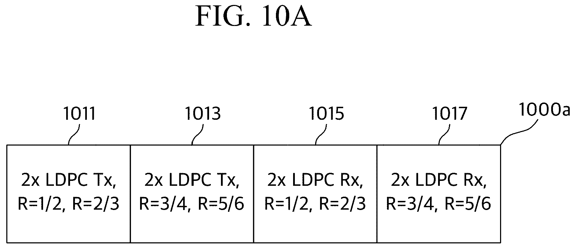

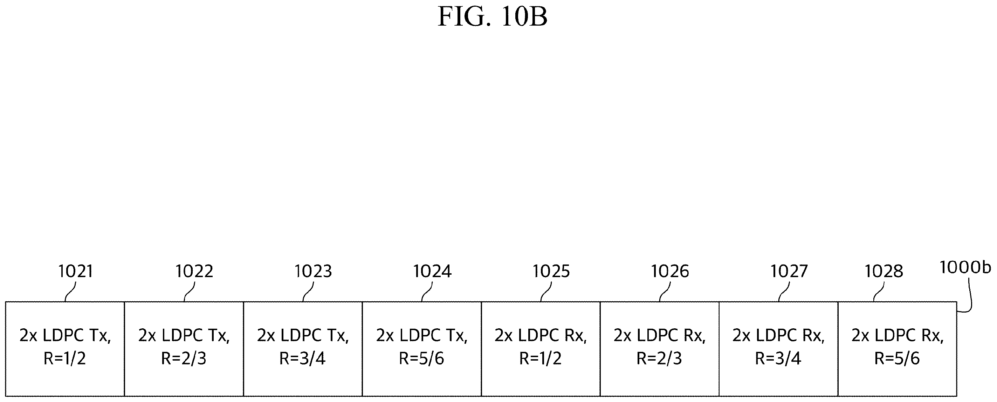

FIG. 10A and FIG. 10B illustrate examples of capability information according to an example embodiment. In an example embodiment, the capability information of FIG. 10A and FIG. 10B may include information indicating whether a specific code rate of a 2xLDPC code is supported.

Referring to FIG. 10A, capability information 1000a may include 2xLDPC Tx bits (a first bit 1011 and a second bit 1013) indicating whether transmission based on the 2xLDPC code is supported, and 2xLDPC Rx bits (a third bit 1015 and a fourth bit 1017) indicating whether reception based on the 2xLDPC code is supported. The 2xLDPC Tx bits (the first bit 1011 and the second bit 1013) and the 2xLDPC Rx bits (the third bit 1015 and the fourth bit 1017) indicate whether the wireless communication device is configured to be used as a transmitter of a 2xLDPC code or a receiver of a 2xLDPC code. In other words, the 2xLDPC Tx bits (the first bit 1011 and the second bit 1013) indicate whether the wireless communication device is configured to encode the 2xLDPC code, and the 2xLDPC Rx bits (the third bit 1015 and the fourth bit 1017) indicate whether the wireless communication device is configured to decode the 2xLDPC code.

The first bit 1011 of the 2xLDPC Tx bits (the first bit 1011 and the second bit 1013) may indicate whether the first code rates in the 2xLDPC code are supported, for example, whether the code rates of R=1/2 and R=2/3 are supported. For example, if the wireless communication device supports transmission at the code rates of R=1/2 and R=2/3 in the 2xLDPC code, the first bit 1011 is represented as 1, and if transmission is not supported at the code rates of R=1/2 and R=2/3 in the 2xLDPC code, the first bit 1011 may be represented as 0.

The second bit 1013 of the 2xLDPC Tx bits (the first bit 1011 and the second bit 1013) may indicate whether the second code rates of R=3/4 and R=5/6 in the 2xLDPC code are supported. For example, if the wireless communication device supports transmission at the code rates of R=3/4 and R=5/6 in the 2xLDPC code, the second bit 1013 is represented as 1, and if transmission is not supported at the code rates of R=3/4 and R=5/6 in the 2xLDPC code, the second bit 1013 may be represented as 0.

Similar to the 2xLDPC Tx bits (the first bit 1011 and the second bit 1013), the 2xLDPC Rx bits (the third bit 1015 and the fourth bit 1017) may include the third bit 1015 indicating whether reception of 2xLDPC code is supported at the first code rates of R=1/2 and R=2/3 and the fourth bit 1017 indicating whether reception of the 2xLDPC code is supported at the second code rates of R=3/4 and R=5/6. If the wireless communication device supports reception at the code rates of R=1/2 and R=2/3 in the 2xLDPC code, the third bit 1015 is represented as 1, and if reception is not supported at the code rates of R=1/2 and R=2/3 in the 2xLDPC code, the third bit 1015 may be represented as 0. If the wireless communication device supports reception at the code rates of R=3/4 and R=5/6 in the 2xLDPC code, the fourth bit 1017 is represented as 1, and if reception is not supported at the code rates of R=3/4 and R=5/6 in the 2xLDPC code, the fourth bit 1017 may be represented as 0.

Referring to FIG. 10B, unlike the capability information 1000a of FIG. 10A, capability information 1000b of FIG. 10B may include bits (bits 1021, 1022, 1023, 1024, 1025, 1026, 1027 and 1028) divided by the supported code rates. One bit may be provided for each potential code rate. The capability information 1000b may include the 8 bits (bits 1021, 1022, 1023, 1024, 1025, 1026, 1027 and 1028) indicating whether transmission or reception is supported depending on each code rate of the 2xLDPC code. Each of the bits (the bits 1021, 1022, 1023, 1024, 1025, 1026, 1027 and 1028) may be represented as 0 or 1 to indicate support. For example, if the wireless communication device supports transmission at the code rate of R=1/2 in the 2xLDPC code, the first bit 1021 is represented as 1, and if reception is not supported at the code rate of R=1/2 in the 2xLDPC code, the first bit 1021 may be represented as 0.

In an example embodiment, capability information of a wireless communication device may include information indicating whether specific modulation coding schemes (MCS) of the 2xLDPC code are supported. Since the MCS information includes code rate information as shown in [Table 3] below, the capability information may indicate whether transmission or reception at a specific code rate of the 2xLDPC code is supported through information indicating whether a specific MCS of 2xLDPC code is supported. Potential modulation coding schemes include Binary-Phase Shift Keying (BPSK), Quadrature Phase-Shift Keying (QPSK), 16 Quadrature Amplitude Modulation (16-QAM), 64-QAM, 256-QAM, 1024-QAM and 4096-QAM.

[Table 3]

| MCS | Modulation | Code rate (R) |
|---|---|---|
| 0 | BPSK | 1/2 |
| 1 | QPSK | 1/2 |
| 2 | QPSK | 3/4 |
| 3 | 16-QAM | 1/2 |
| 4 | 16-QAM | 3/4 |
| 5 | 64-QAM | 2/3 |
| 6 | 64-QAM | 3/4 |
| 7 | 64-QAM | 5/6 |
| 8 | 256-QAM | 3/4 |
| 9 | 256-QAM | 5/6 |
| 10 | 1024-QAM | 3/4 |
| 11 | 1024-QAM | 5/6 |
| 12 | 4096-QAM | 3/4 |
| 13 | 4096-QAM | 5/6 |

As shown in [Table 3], when the MCS index is 2, 4, 6, 7, 8, 9, 10, 11, 12 and 13, the code rate is 3/4 or 5/6 and when the data is encoded with the 2xLDPC code, the receiver may decode the signal that is encoded with the 2xLDPC code of the memory size of the 1xLDPC code. Therefore, the wireless communication device that performs transmission and reception may include in the capability information whether the at least one MCS index among 2, 4, 6, 7, 8, 9, 10, 11, 12, and 13 is supported by the 2xLDPC code and whether the remaining MCS indexes or all MCS indices are supported. As with the examples of FIGS. 10A and 10B, if a bit is represented as 1, then the MCS index reflected by that particular bit is supported, and if a bit is represented as 0, then the MCS index reflected by that particular bit is not supported.

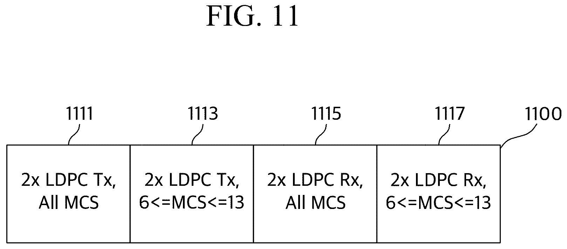

FIG. 11 is a diagram illustrating capability information according to an example embodiment. For example, FIG. 11 illustrates capability information based on MCS.

Referring to FIG. 11, capability information 1100 may include 2xLDPC Tx bits (a first bit 1111 and a second bit 1113) indicating whether transmission based on 2xLDPC code is supported, and 2xLDPC Rx bits (a third bit 1115 and a fourth bit 1117) indicating whether reception based on the 2xLDPC code is supported. The 2xLDPC Tx bits (the first bit 1111 and the second bit 1113) and the 2xLDPC Rx bits (the third bit 1115 and the fourth bit 1117) indicate whether the wireless communication device is configured to be used as a transmitter of the 2xLDPC code or a receiver of the 2xLDPC code. For example, the 2xLDPC Tx bits (the first bit 1111 and the second bit 1113) indicate whether the wireless communication device is configured to encode 2xLDPC codes, and the 2xLDPC Rx bits (the third bit 1115 and the fourth bit 1117) indicate whether the wireless communication device is configured to decode the 2xLDPC codes.

The first bit 1111 of the 2xLDPC Tx bits (the first bit 1111 and the second bit 1113) may indicate whether all MCS indices are supported by 2xLDPC code. For example, if the wireless communication device supports transmission of all MCS indices in the 2xLDPC code, the first bit 1111 may be 1, and if the 2xLDPC code does not support transmission of all MCS indices, the first bit 1111 may be 0.

The second bit 1113 of the 2xLDPC Tx bits (the first bit 1111 and the second bit 1113) may indicate whether the 2xLDPC code supports a subset of the MCS indices (e.g., 6, 7, 8, 9, 10, 11, 12 and 13). For example, if the wireless communication device supports transmission when the MCS index is 6, 7, 8, 9, 10, 11, 12 and 13 in the 2xLDPC code, the second bit 1113 may be 1, and if the wireless communication device does not support transmission when the MCS index is 6, 7, 8, 9, 10, 11, 12 and 13 in the 2xLDPC code, the second bit 1113 may be 0.

Similar to the 2xLDPC Tx bits (the first bit 1111 and the second bit 1113), the 2xLDPC Rx bits (the third bit 1115 and the fourth bit 1117) may also include the third bit 1115 indicating whether reception of 2xLDPC codes is supported at all MCS indices, and the fourth bit 1117 indicating whether reception of 2xLDPC code is supported when the MCS index is one of a subset (e.g., 6, 7, 8, 9, 10, 11, 12 and 13).

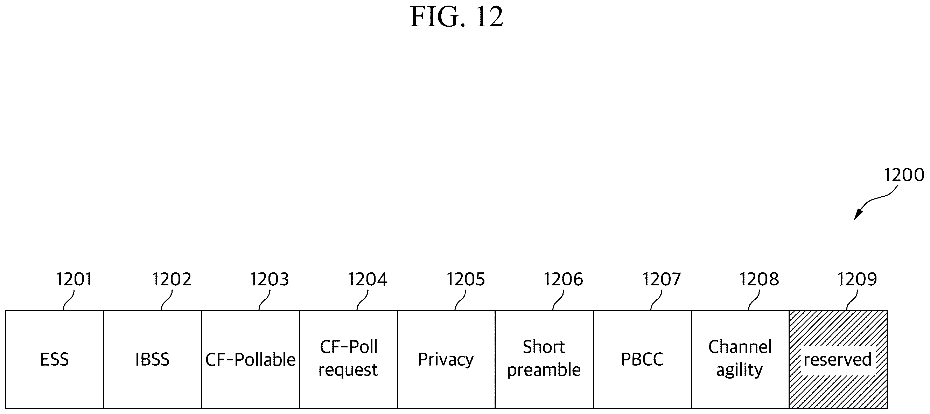

FIG. 12 illustrates capability information according to an example embodiment. For example, the capability information shown in FIG. 12 indicates capability information according to the IEEE 802.11 standard, and may indicate information separate from the capability information described above.

Referring to FIG. 12, capability information 1200 may be 16 bit information which includes an extended service set (ESS) 1201, an independent basic service set (IBSS) 1202, contention-free pollable (CF-Pollable) 1203, a contention-free poll request (CF-Poll request) 1204, privacy 1205, a short preamble 1206, packet binary convolutional coding (PBCC) 1207, channel agility 1208 and reserved bits 1209.

The ESS 1201 and the IBSS 1202 may be set to mutually exclusive bits. The access point 510 may indicate that it is part of an infrastructure network by setting the ESS 1201 to 1 and the IBSS 1202 to 0. The station 520 belonging to the IBSS 1202 may set the ESS 1201 to 0 and the IBSS 1202 to 1 to form an ad-hoc network that allows direct communication between stations.

The CF-Pollable 1203 may include one bit of information indicating whether the station may transmit and receive data through polling in a contention-free manner. This may be used to support access points in wireless networks to control the order of data transmission.

The CF-Poll Request 1204 indicates the polling request function in contention-free mode, and may include one bit of information indicating whether the station may request data transmission to the access point. Further, the CF-Poll Request 1204 may help improve the efficiency of data transmission.

The privacy 1205 indicates whether security features are supported on the wireless network, and if the corresponding bit is set to 1, the privacy 1205 may indicate that wired equivalent privacy (WEP) should be used for confidentiality. In an infrastructure network, the transmitter is an access point, and in the IBSS 1202, beacon transmissions may be processed by the stations of the IBSS 1202.

The short preamble 1206 is a 1-bit field added to the 802.11b standard, and may indicate bits designed to support high-speed direct sequence spread spectrum (DSSS) PHY. If the short preamble 1206 is set to 1, it indicates that the network uses a short preamble, which contributes to improving network efficiency. If the short preamble 1206 is set to 0, then the short preamble 1206 is not being used, and this may indicate that the short preamble 1206 is prohibited in the BSS.

The PBCC 1207 is a 1-bit field added to the 802.11b standard to support high-speed DSSS PHY. When the PBCC 1207 is set to 1, it indicates that the network uses packet binary convolutional coding modulation scheme. When the PBCC 1207 is set to 0, the network does not use packet binary convolutional coding modulation, and this may indicate that the PBCC 1207 is prohibited in the BSS.

The channel agility 1208 is a 1-bit field added to the 802.11b standard to support high-speed DSSS PHY, and when the channel agility 1208 is set to 1, it may indicate that the network is using the channel agility option. Using the option of the channel agility 1208 may minimize network interference and support efficient use of frequency bands. When the channel agility 1208 is set as 0, then the channel agility 1208 is not being used, and it may indicate that the channel agility 1208 is prohibited in the BSS.

The reserved bits 1209 may indicate unused bits in the capability information 1200. For example, unused bits, or the reserved bits 1209 may be 8 bits. In an example embodiment, capability information (the capability information 1000a, the capability information 1000b and the capability information 1100) of FIG. 10A, FIG. 10B and FIG. 11 may be included as the reserved bits 1209.

FIG. 13 is a drawing showing examples of devices for wireless communication according to an example embodiment. Specifically, FIG. 13 illustrates an Internet of Things (IoT) network system including home gadget 1301, home appliances 1302, entertainment devices 1303 and an access point 1305. In some example embodiments, among the devices for the wireless communication of FIG. 13, as described above with reference to the drawings, capability information may be transmitted, including information about the supported code rates. Accordingly, the devices for wireless communications may decode codewords of extended length using limited memory, and thus the cost may be reduced and the reliability may be increased.

Embodiments are set out in the following Clauses:

Clause 1. A wireless communication method by a first device, the method comprising:

transmitting, to a second device, first capability information that identifies at least one code rate supported by a first low density parity check (LDPC) code; and
receiving a signal that is encoded based on the first capability information and the first LDPC code.

Clause 2. The wireless communication method of Clause 1, wherein the first capability information indicates whether transmission based on the first LDPC code is supported and whether reception based on the first LDPC code is supported.

Clause 3. The wireless communication method of Clause 1 or Clause 2, wherein the first capability information comprises:

a first bit indicating whether at least one first code rate of the first LDPC code is supported; and
a second bit indicating whether at least one second code rate of the first LDPC code is supported.

Clause 4. The wireless communication method of any preceding Clause, further comprising receiving, from the second device, second capability information that identifies at least one code rate that the second device supports in the first LDPC code.

Clause 5. The wireless communication method of Clause 4, wherein receiving the second capability information from the second device comprises receiving a probe request frame that includes the second capability information from the second device.

Clause 6. The wireless communication method of Clause 4 or Clause 5, further comprising:

determining a third code rate that is identical to at least one code rate that is supported by the first device and the second device; and
transmitting information that identifies the third code rate to the second device,
wherein receiving the signal that is encoded based on the first capability information and the first LDPC code comprises receiving the signal that is encoded with the first LDPC code of the third code rate.

Clause 7. The wireless communication method of any preceding Clause, wherein the first LPDC code has a length of a first maximum codeword,

wherein the first device and the second device are configured to support a second LPDC code having a length of a second maximum codeword, and
wherein the first maximum codeword is longer than the second maximum codeword.

Clause 8. The wireless communication method of Clause 7, wherein the first capability information includes information identifying at least one modulation and coding scheme (MCS) index.

Clause 9. The wireless communication method of Clause 8, wherein the first capability information identifying the at least one MCS index comprises at least one of:

a first bit indicating whether transmission of the first LDPC code is supported in all MCS indices;
a second bit indicating whether transmission of the first LDPC code is supported in MCS indices that are 6 or greater and 13 or less;
a third bit indicating whether reception of the first LDPC code is supported in all MCS indices; and
a fourth bit indicating whether reception of the first LDPC code is supported in the MCS indices that are 6 or greater and 13 or less.

Clause 10. The wireless communication method of any of Clauses 7-9, wherein the first capability information identifying the at least one code rate comprises at least one of:

a fifth bit indicating whether transmission of the first LDPC code is supported at a code rate of 1/2 and 2/3;
a sixth bit indicating whether transmission of the first LDPC code is supported at a code rate of 3/4 and 5/6;
a seventh bit indicating whether reception of the first LDPC code is supported at the code rate of 1/2 and 2/3; and
an eighth bit indicating whether reception of the first LDPC code is supported at the code rate of 3/4 and 5/6.

Clause 11. The wireless communication method of any preceding Clause, wherein transmitting the first capability information to the second device comprises transmitting a beacon frame or a probe response frame including the first capability information to the second device.

Clause 12. A wireless communication method by a first device, the method comprising:

receiving, from the second device, second capability information that identifies at least one code rate that is supported by the first LDPC code of the second device;
encoding a signal based on the second capability information and the first LDPC code; and
transmitting, to the second device, the signal encoded based on the first capability information and the first LDPC code.

Clause 13. The wireless communication method of Clause 12, wherein the second capability information indicates whether transmission based on the first LDPC code is supported and whether reception based on the first LDPC code is supported.

Clause 14. The wireless communication method of Clause 12 or Clause 13, further comprising:

determining a third code rate that is identical to at least one code rate that is supported by the first device and the second device; and
transmitting information that identifies the third code rate to the second device,
wherein transmitting the signal that is encoded based on an analysis of the first capability information and the second capability information and the first LDPC code comprises transmitting or receiving the signal that is encoded with the first LDPC code of the third code rate.

Clause 15. A first device configured to communicate with a second device, the first device comprising:

a transceiver; and
a processor configured to transmit and receive signals to and from the transceiver,
wherein the transceiver is configured to:

transmit, to the second device, first capability information that identifies at least one code rate supported by a first LDPC code of the first device; and
receive a signal that is encoded based on the first capability information and the first LDPC code.

As described above, example embodiments are disclosed with respect to the drawings in the present disclosure. In the present disclosure, the example embodiments are described using specific terms, but the terms are used solely for the purpose of explaining the technical ideas of the present disclosure and are not intended to limit the meaning or scope of the present disclosure as set forth in the claims. Therefore, those skilled in the art will understand that various modifications and equivalent example embodiments are possible

**Claims**

1. A wireless communication method by a first device (510), the method comprising:

   transmitting (S630), to a second device (520), first capability information that identifies at least one code rate supported by a first low density parity check, LDPC, code; and
   receiving (S660) a signal that is encoded based on the first capability information and the first LDPC code.

2. The wireless communication method of claim 1, wherein the first capability information indicates whether transmission based on the first LDPC code is supported and whether reception based on the first LDPC code is supported.

3. The wireless communication method of claim 1 or claim 2, wherein the first capability information comprises:

   a first bit indicating whether at least one first code rate of the first LDPC code is supported; and
   a second bit indicating whether at least one second code rate of the first LDPC code is supported.

4. The wireless communication method of any preceding claim, further comprising receiving (S640), from the second device (520), second capability information that identifies at least one code rate that the second device (520) supports in the first LDPC code.

5. The wireless communication method of claim 4, wherein receiving (S640) the second capability information from the second device (520) comprises receiving a probe request frame that includes the second capability information from the second device (520).

6. The wireless communication method of claim 4 or claim 5, further comprising:

   determining a third code rate that is identical to at least one code rate that is supported by the first device (510) and the second device (520); and

transmitting information that identifies the third code rate to the second device (520),
wherein receiving the signal that is encoded based on the first capability information and the first LDPC code comprises receiving the signal that is encoded with the first LDPC code of the third code rate.

7. The wireless communication method of any preceding claim, wherein the first LPDC code has a first maximum codeword length,

wherein the first device (510) and the second device (520) are configured to support a second LPDC code having a second maximum codeword length, and
wherein the first maximum codeword length is longer than the second maximum codeword length.

8. The wireless communication method of claim 7, wherein the first capability information includes information identifying at least one modulation and coding scheme, MCS, index.

9. The wireless communication method of claim 8, wherein the first capability information identifying the at least one MCS index comprises at least one of:

a first bit indicating whether transmission of the first LDPC code is supported in all MCS indices;
a second bit indicating whether transmission of the first LDPC code is supported in MCS indices that are 6 or greater and 13 or less;
a third bit indicating whether reception of the first LDPC code is supported in all MCS indices; and
a fourth bit indicating whether reception of the first LDPC code is supported in the MCS indices that are 6 or greater and 13 or less.

10. The wireless communication method of any of claims 7-9, wherein the first capability information identifying the at least one code rate comprises at least one of:

a fifth bit indicating whether transmission of the first LDPC code is supported at code rates of 1/2 and 2/3;
a sixth bit indicating whether transmission of the first LDPC code is supported at code rates of 3/4 and 5/6;
a seventh bit indicating whether reception of the first LDPC code is supported at the code rates of 1/2 and 2/3; and
an eighth bit indicating whether reception of the first LDPC code is supported at the code rates of 3/4 and 5/6.

11. The wireless communication method of any preceding claim, wherein transmitting the first capability information to the second device (520) comprises transmitting a beacon frame or a probe response frame including the first capability information to the second device (520).

12. A wireless communication method by a first device (510), the method comprising:

receiving (S530), from a second device (520), second capability information that identifies at least one code rate that is supported by a first LDPC code of the second device (520);
encoding (S550) a signal based on the second capability information and the first LDPC code; and
transmitting (S560), to the second device (520), the signal encoded based on the second capability information and the first LDPC code.

13. The wireless communication method of claim 12, wherein the second capability information indicates whether transmission based on the first LDPC code is supported and whether reception based on the first LDPC code is supported.

14. The wireless communication method of claim 12 or claim 13, further comprising:

determining a third code rate that is identical to at least one code rate that is supported by the first device (510) and the second device (520); and
transmitting (S530) information that identifies the third code rate to the second device (520),
wherein transmitting (S560) the signal that is encoded based the second capability information and the first LDPC code comprises transmitting or receiving the signal that is encoded with the first LDPC code of the third code rate.

15. A first device (510) configured to communicate with a second device (520), the first device (510) comprising:

a transceiver (21b); and
a processor (21c) configured to control the transceiver (21b) to transmit and receive signals,
wherein processor (21c) is configured to control the transceiver (21b) to:

transmit (S630), to the second device (510), first capability information that identifies at least one code rate supported by a first LDPC code of the first device (510); and
receive (S660) a signal that is encoded based on the first capability information and the first LDPC code.

# FIG. 1

# FIG. 2

FIG. 3A

$$H = \begin{bmatrix} 1 & 1 & 0 & 1 & 1 & 0 & 0 \\ 0 & 1 & 1 & 1 & 0 & 1 & 0 \\ 1 & 0 & 1 & 1 & 0 & 0 & 1 \end{bmatrix} \begin{matrix} 301 \\ 303 \\ 305 \end{matrix}$$

# FIG. 3B

FIG. 4A

FIG. 4B

FIG. 4C

## FIG. 4D

# FIG. 5

```
          AP        ──510        520──      STA

Identify code rate supported          S520──  Identify code rate supported
  by first LDPC code      ──S510              by first LDPC code

                        S530
              Transmit first capability information
                       of access point
                          S540
          Transmit second capability information of station

Encode data in first LDPC code
  based on first capability          ──S550
 information and second
  capability information
                           S560
                   Transmit coded signal

                             S570──
                                      Decode received signal
```

# FIG. 6

# FIG. 7A

Start

Identify code rate supported by first LDPC code — S711

Transmit first capability information — S713

Based on first capability information and first LDPC code, receive or transmit coded signal — S715

End

# FIG. 7B

```
            ( Start )
                |
                v
+-------------------------------------------+
| Receive second capability information      |
| including code rate supported by first     |   ~ S721
| LDPC code                                   |
+-------------------------------------------+
                |
                v
+-------------------------------------------+
| Receive or transmit coded signal based on  |
| second capability information and first     |   ~ S723
| LDPC code                                   |
+-------------------------------------------+
                |
                v
            ( End )
```

# FIG. 8

```
                    ┌─────────────┐
                    │    Start    │
                    └─────────────┘
                           │
                           ▼
        ┌──────────────────────────────────────┐
        │  Determine code rate in first LDPC code │ ─── S810
        └──────────────────────────────────────┘
                           │
                           ▼
        ┌──────────────────────────────────────┐
        │ Transmit determined code rate of first LDPC code │ ─── S820
        └──────────────────────────────────────┘
                           │
                           ▼
        ┌──────────────────────────────────────┐
        │ Encode data according to code rate of first LDPC code │ ─── S830
        └──────────────────────────────────────┘
                           │
                           ▼
        ┌──────────────────────────────────────┐
        │           Transmit coded signal          │ ─── S840
        └──────────────────────────────────────┘
                           │
                           ▼
                    ┌─────────────┐
                    │     End     │
                    └─────────────┘
```

# FIG. 9

Start

Determine code rate from first LDPC code ~S910

Transmit determined code rate of first LDPC code ~S920

Receive coded signal ~S930

Decode received signal ~S940

End

# FIG. 10A

| 2x LDPC Tx, R=1/2, R=2/3 | 2x LDPC Tx, R=3/4, R=5/6 | 2x LDPC Rx, R=1/2, R=2/3 | 2x LDPC Rx, R=3/4, R=5/6 |
|---|---|---|---|

1011     1013     1015     1017     1000a

## FIG. 10B

EP 4 757 221 A1

| 2x LDPC Tx, R=1/2 | 2x LDPC Tx, R=2/3 | 2x LDPC Tx, R=3/4 | 2x LDPC Tx, R=5/6 | 2x LDPC Rx, R=1/2 | 2x LDPC Rx, R=2/3 | 2x LDPC Rx, R=3/4 | 2x LDPC Rx, R=5/6 |
|---|---|---|---|---|---|---|---|
| 1021 | 1022 | 1023 | 1024 | 1025 | 1026 | 1027 | 1028 |

1000b

FIG. 11

| 2x LDPC Tx, All MCS | 2x LDPC Tx, 6<=MCS<=13 | 2x LDPC Rx, All MCS | 2x LDPC Rx, 6<=MCS<=13 |
|---|---|---|---|

1111     1113     1115     1117     1100

EP 4 757 221 A1

# FIG. 12

1200

| ESS | IBSS | CF-Pollable | CF-Poll request | Privacy | Short preamble | PBCC | Channel agility | reserved |
|------|------|-------------|-----------------|---------|----------------|------|-----------------|----------|
| 1201 | 1202 | 1203 | 1204 | 1205 | 1206 | 1207 | 1208 | 1209 |

# FIG. 13

Home Gadget 1301

1302

1305

Access Point

Home Appliances

1303

Entertainment

Europäisches
Patentamt

European
Patent Office

Office européen
des brevets

# EUROPEAN SEARCH REPORT

**Application Number**

EP 25 22 0391

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/288708 A1 (MA LIANG [CN] ET AL) 19 September 2019 (2019-09-19) * paragraph [0011] - paragraph [0022] * * figure 4 * * paragraph [0147] * ----- | 1-15 | INV. H04L1/00 |
| Y | US 2023/418704 A1 (NIE ER [CN] ET AL) 28 December 2023 (2023-12-28) * paragraphs [0015], [0035], [0036] * * paragraph [0136] - paragraph [0139] * ----- | 1-15 | |

**TECHNICAL FIELDS SEARCHED (IPC)**

H04L
H03M

The present search report has been drawn up for all claims

| Place of search | Date of completion of the search | Examiner |
|---|---|---|
| Munich | 15 April 2026 | Stolte, Norbert |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 22 0391

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2026

| Patent document cited in search report | Publication date | Patent family member(s) | Publication date |
|---|---|---|---|
| US 2019288708 A1 | 19-09-2019 | CN 108173621 A | 15-06-2018 |
| | | EP 3540947 A1 | 18-09-2019 |
| | | JP 6886515 B2 | 16-06-2021 |
| | | JP 2020504932 A | 13-02-2020 |
| | | US 2019288708 A1 | 19-09-2019 |
| US 2023418704 A1 | 28-12-2023 | CN 116941200 A | 24-10-2023 |
| | | EP 4283893 A1 | 29-11-2023 |
| | | US 2023418704 A1 | 28-12-2023 |
| | | WO 2022187993 A1 | 15-09-2022 |

EPO FORM P0459

For more details about this annex : see Official Journal of the European Patent Office, No. 12/82